# EUROPÄISCHE PATENTSCHRIFT

(11) **EP 3 262 358 B1**
(45) Veröffentlichungstag und Bekanntmachung des Hinweises auf die Patenterteilung: **11.03.2020**
(21) Anmeldenummer: 16701653.4
(22) Anmeldetag: 27.01.2016
(51) Int. Cl.: F25D 29/00, F25D 23/02

(54) **HAUSHALTSKÄLTEGERÄT UND VERFAHREN ZUM BETREIBEN EINES HAUSHALTSKÄLTEGERÄTES**
DOMESTIC REFRIGERATION APPLIANCE AND METHOD FOR OPERATING A DOMESTIC REFRIGERATION APPLIANCE
APPAREIL FRIGORIFIQUE ÉLECTROMÉNAGER ET PROCÉDÉ PERMETTANT DE FAIRE FONCTIONNER UN APPAREIL FRIGORIFIQUE ÉLECTROMÉNAGER

(30) Priorität: 23.02.2015 DE 102015203150
(43) Veröffentlichungstag der Anmeldung: 03.01.2018
(73) Patentinhaber: BSH Hausgeräte GmbH, 81739 München (DE)
(72) Erfinder: GEBLER, Martin, 82049 Pullach (DE); GRIMMINGER, Jochen, 86660 Tapfheim (DE); LINDEL, Andreas, 89522 Heidenheim (DE); SCHMID, Christian, 73432 Aalen (DE); WERNER, Hans Peter, 89537 Giengen (DE); WETZL, Gerhard, 89567 Sontheim (DE)
(86) Internationale Anmeldenummer: PCT/EP2016/051676
(87) Internationale Veröffentlichungsnummer: WO 2016/134912

(56) Entgegenhaltungen:
- EP-A1- 2 792 980
- WO-A1-2014/175643
- WO-A1-2015/004918
- JP-A- 2004 324 980
- US-A- 4 241 337

## Beschreibung

Die Erfindung betrifft ein Haushaltskältegerät und ein Verfahren zum Betreiben eines Haushaltskältegerätes.

Die EP 2 792 980 A1 offenbart ein Haushaltskältegerät, das eine insbesondere als Kältemittelkreislauf ausgeführte Kältevorrichtung und ein wärmeisoliertes Gehäuse mit einem zum Lagern von Lebensmitteln vorgesehenen kühlbaren Innenraum, der mittels der Kältevorrichtung gekühlt wird. Das Haushaltskältegerät umfasst ferner ein am Gehäuse mit Scharnieren schwenkbar gelagertes Türblatt zum Öffnen und Verschließen des kühlbaren Innenraums. Das Haushaltskältegerät der EP 2 792 980 A1 weist eine Kameravorrichtung und eine Erkennungseinheit auf, die einen optischen Sensor, einen mechanischen Schalter, einen Magnetsensor oder eine Kamera umfassen kann. Die Erkennungseinheit ist ausgebildet, ein Öffnen und ein Schließen des Türblatts und einen Öffnungswinkel des Türblatts durch ein Auswerten von von den Sensoren erzeugten Signalen und mittels der Kamera erstellter Bilder zu erkennen. Das Haushaltskältegerät ist eingerichtet, die Kameravorrichtung beim Öffnen des Türblatts in einen Stand-By Modus zu schalten. Um ein Bild vom Inneren des kühlbaren Innenraums anzufertigen, löst beim sich schließenden Türblatt die Kameravorrichtung bei einem Öffnungswinkel kleiner einem vorbestimmten Öffnungswinkel aus, indem bei sich schließendem Türblatt dessen Öffnungswinkel mit dem vorbestimmten Öffnungswinkel verglichen wird.

Die JP 2004324980 A offenbart ein Haushaltskältegerät, das ein wärmeisoliertes Gehäuse, das einen zum Lagern von Lebensmitteln vorgesehenen, durch eine Öffnung zugänglichen kühlbaren Innenraum begrenzt, ein mit wenigstens einem Scharnier bezüglich einer Achse schwenkbar gelagertes Türblatt zum Öffnen und Verschließen der Öffnung des Gehäuses, und eine zum Abdecken des Scharniers vorgesehene Abdeckung. Innerhalb der Abdeckung ist ein Hallsensor angeordnet und an dem Türblatt ist ein Magnet derart angeordnet, dass sich der Magnet bei geschlossenem Türblatt im Wirkbereich des Magneten befindet.

WO 2014/175643 A1 und US 4241337 A1 offenbaren ähnliche Kältegeräte.

Aufgabe der vorliegenden Erfindung ist es, ein verbessertes Haushaltskältegerät mit einem kühlbaren Innenraum und einem zum Öffnen und Verschließen des kühlbaren Innenraums vorgesehenen Türblatt anzugeben.

Die Aufgabe der Erfindung wird gelöst durch ein Haushaltskältegerät gemäß dem Patentanspruch 1.

Das erfindungsgemäße Haushaltskältegerät umfasst das wärmeisolierte Gehäuse, das den kühlbaren Innenraum begrenzt. Dieser wird mittels der Kältevorrichtung gekühlt. Diese ist vorzugsweise als ein dem Fachmann im Prinzip bekannter Kältemittelkreislauf ausgebildet und ist vorzugsweise derart ausgeführt, dass er den kühlbaren Innenraum zumindest in etwa auf eine vorgegebene Temperatur kühlt.

Der kühlbare Innenraum kann mittels des Türblatts verschlossen werden. Das Türblatt ist bezüglich der Achse, die vorzugsweise vertikal verläuft, schwenkbar mittels des wenigstens einen Scharniers gelagert. Im geöffneten Zustand ist der kühlbare Innenraum durch die Öffnung des Gehäuses zugänglich.

Das Gehäuse kann eine nach oben gerichtete obere Wand mit einer dem kühlbaren Innenraum abgewandten Seite aufweisen. Vorzugsweise ist das Scharnier an dieser Seite der oberen Wand z.B. mittels Schrauben befestigt.

Das erfindungsgemäße Haushaltsgerät umfasst die Vorrichtung, welche mittels der Auslösevorrichtung in Abhängigkeit des Öffnungswinkels des Türblatts angesteuert wird bzw. aktivierbar ist. Gemäß einer bevorzugten Ausführungsform des erfindungsgemäßen Haushaltskältegerätes handelt es sich bei dieser Vorrichtung um eine Kamera, welche eingerichtet ist, angesteuert durch die Auslösevorrichtung ein Bild vom kühlbaren Innenraum zu erstellen. Gemäß dieser Variante des erfindungsgemäßen Haushaltsgerätes umfasst dieses also wenigstens eine Kamera, wobei die Auslösevorrichtung eingerichtet ist, die wenigstens eine Kamera des Haushaltskältegerätes in Abhängigkeit eines Öffnungswinkels des Türblatts derart anzusteuern, sodass die wenigstens eine Kamera ein Bild vom kühlbaren Innenraum erstellt.

Das erfindungsgemäße Haushaltskältegerät kann eine Schnittstelle aufweisen, über die das Bild bzw. ein dem Bild zugeordneter Bilddatensatz an ein vom Haushaltskältegerät unabhängig betreibbares Gerät übertragbar ist. Das Gerät ist z.B. ein an das Internet angeschlossener Rechner oder ein mobiles Endgerät, z.B. ein Smartphone oder ein Tablet-PC. Insbesondere kann das Haushaltskältegerät über die Schnittstelle den Bilddatensatz über das Internet oder eine andere Kommunikationsverbindung an das Gerät übermitteln. Dadurch ist es einer Person möglich, ein Bild vom aktuellen Inhalt des Haushaltskältegerätes fern vom Haushaltskältegerät anzusehen, um sich z.B. über den aktuellen Lagerbestand von im kühlbaren Innenraum gelagerten Lebensmittel zu informieren.

Das erfindungsgemäße Haushaltskältegerät umfasst ferner die Abdeckung, welche vorgesehen ist, das Scharnier abzudecken. Erfindungsgemäß ist auch die Auslösevorrichtung innerhalb der Abdeckung angeordnet. Somit deckt die Abdeckung nicht nur das Scharnier ab, sondern auch die Auslösevorrichtung. Die Abdeckung ist vorzugsweise aus Kunststoff.

Vorzugsweise ist die Auslösevorrichtung des erfindungsgemäßen Haushaltskältegerätes derart eingerichtet, dass sie die wenigstens eine Vorrichtung, insbesondere die wenigstens eine Kamera nur bei einem Schwenken des Türblatts von seiner geöffneten Stellung in seine geschlossene Stellung insbesondere bei einem vorbestimmten Öffnungswinkel ansteuert. Ist z.B. die Vorrichtung die Kamera und ist diese in oder an der dem kühlbaren Innenraum zugewandten Seite des Türblatts befestigt, dann kann dieser Öffnungswinkel derart auf den Aufnahmewinkel der Kamera eingestellt sein, dass das mit der Kamera erstellte Bild möglichst den gesamten kühlbaren Innenraum abbildet. Außerdem bildet, da im Falle der Kamera als Vorrichtung das Bild vom kühlbaren Innenraum nur bei sich schließendem Türblatt erstellt wird, das Bild den aktuellen Lagerbestand an Lebensmitteln im kühlbaren Innenraum ab. Gemäß dieser Variante ist demnach vorzugsweise die Auslösevorrichtung eingerichtet, die wenigstens eine Kamera des Haushaltskältegerätes nur beim Schwenken des Türblatts von seiner geöffneten Stellung in seine geschlossene Stellung beim vorbestimmten Öffnungswinkel des Türblatts derart anzusteuern, sodass die wenigstens eine Kamera ein Bild vom kühlbaren Innenraum erstellt, wenn das Türblatt den vorbestimmten Öffnungswinkel einnimmt.

Die Auslösevorrichtung des erfindungsgemäßen Haushaltskältegerätes ist nach einer bevorzugten Ausführungsform neben dem Scharnier innerhalb der Abdeckung angeordnet. Die Abdeckung weist dazu insbesondere eine Trennwand auf, welche die Auslösevorrichtung von dem Scharnier trennt.

Die Auslösevorrichtung ist als ein Magnetsensor ausgebildet oder weist einen Magnetsensor auf, der innerhalb der Abdeckung angeordnet ist und mit einem in oder an dem Türblatt befestigten Dauermagneten für das Ansteuern der Vorrichtung zusammenwirkt. Dadurch kann die Auslösevorrichtung berührungslos ausgeführt werden, was wiederum der Lebensdauer förderlich ist.

Der Dauermagnet ist vorzugsweise in dem dem Scharnier zugewandten Bereich des Türblatts befestigt. Ist das Scharnier an der oberen Wand des Gehäuses befestigt, dann ist vorzugsweise der Dauermagnet im oberen Bereich des Türblatts, vorzugsweise in oder an einer oberen Abschlussleiste des Türblatts befestigt.

Vorzugsweise kann der Magnetsensor innerhalb der Abdeckung derart angeordnet, insbesondere befestigt sein, dass er an einer vorbestimmten Stelle vor der Stirnseite des Gehäuses angeordnet ist, sodass der der Dauermagnet sich dann im Wirkbereich des Magnetsensors befindet, wenn das Türblatt einen vorbestimmten Öffnungswinkel aufweist.

Der Dauermagnet ist derart im oder am Türblatt angeordnet, dass dessen Nordpol und Südpol horizontal vorzugsweise in Schwenkrichtung des Türblatts ausgerichtet sind, sodass beim Schwenken des Türblatts über den vorbestimmten Öffnungswinkel der Magnetsensor einen Nordpol/Südpol Wechsel und einen Südpol/Nordpol Wechsel des Dauermagneten, also eine Poländerung des Dauermagneten zu erkennen vermag. Somit wird ein in der Länge definierter Dauermagnet verwendet, dessen Südpol/Nordpol oder Nordpol/Südpol Wechsel in der Horizontalen angeordnet ist. Um eine möglichst hohe Genauigkeit zu erreichen, wird der Dauermagnet nur noch in einer Richtung genau positioniert. Die Auslösung erfolgt mit Hilfe des Magnetsensors, der fest fixiert im Türscharnier bzw. dessen Abdeckung verbaut ist. Der Magnetsensor kann relativ genau auf den Südpol/Nordpol oder Nordpol/Südpol Wechsel reagieren, der immer in der Mittleren Spiegelachse (Äquator des Dauermagneten) verläuft. Somit ergibt sich eine relativ einfache, günstige und auch zuverlässige Auslösevorrichtung. Diese Magnetanordnung kann auch mehrfach entlang der Horizontalen wiederholt werden, wodurch eine nur durch die Größe der Dauermagnete bestimmte Wickelmessung günstig möglich wird.

Der Magnetsensor ist z.B. ein Hall-Sensor.

Vorzugsweise ist der Magnetsensor ein unipolarer Magnetsensor. Ein solcher Magnetsensor ist je nach Typ Südpol oder Nordpol sensitiv, ist also empfindlicher gegenüber dem Detektieren des Südpols bzw. des Nordpols. Um bei Schließen des Türblatts den vorbestimmten Öffnungswinkel mit relativ hoher Genauigkeit zu erkennen, sind vorzugsweise die Pole des Dauermagneten derart ausgerichtet, dass derjenige Pol vom Gehäuse abgewandt ist, auf den der unipolare Magnetsensor mit höherer Empfindlichkeit reagiert.

Ist also der Südpol des Dauermagneten vom Gehäuse abgewandt, dann ist der unipolare Magnetsensor vorzugsweise Südpol empfindlich.

Ist dagegen der Südpol des Dauermagneten dem Gehäuse zugewandt, dann ist der unipolare Magnetsensor vorzugsweise Nordpol empfindlich.

Vorzugsweise befindet sich der Magnetsensor in der Drehflucht des Dauermagneten, d.h. bei dem vorbestimmten Öffnungswinkel befindet sich der Magnetsensor direkt über dem Dauermagneten.

Ein weiterer Aspekt der Erfindung betrifft ein Verfahren zum Betreiben des erfindungsgemäßen Haushaltskältegerätes, aufweisend folgende Verfahrensschritte:
- Schwenken des Türblatts, und
- Auswerten der von dem Magnetsensor erzeugten Signale während des Schwenkens des Türblatts, um einen Nordpol/Südpol Wechsel oder einen Südpol/Nordpol Wechsel des Dauermagneten beim Schwenken des Türblatts über den vorbestimmten Öffnungswinkel zu erkennen, um daraufhin die Vorrichtung auszulösen, vorzugsweise die Vorrichtung nur bei sich schließendem Türblatt auszulösen.

Gemäß einer bevorzugten Ausführungsform des erfindungsgemäßen Haushaltskältegeräts bzw. des erfindungsgemäßen Verfahrens ist es vorgesehen, dass ein Öffnen des Türblatts insbesondere durch Auswerten von Signalen, die ein Türöffnungsschalter des Haushaltskältegerätes beim Öffnen des Türblatts erzeugt, erkannt wird. Ein Türöffnungsschalter wird z.B. auch verwendet, um eine gegebenenfalls vorhandene Innenraumbeleuchtung zum Beleuchten des kühlbaren Innenraums bei geöffnetem Türblatt einzuschalten. Danach werden die von dem Magnetsensor erzeugten Signale während des Schwenkens des Türblatts ausgewertet, um insbesondere einen Nordpol/Südpol Wechsel oder einen Südpol/Nordpol Wechsel des Dauermagneten beim Schwenken des Türblatts über den vorbestimmten Öffnungswinkel zu erkennen. Die Vorrichtung wird nur dann ausgelöst, wenn nach dem erkannten Öffnen des Türblatts aufgrund des Auswertens der vom Magnetsensor erzeugten Signale erkannt wird, dass das Türblatt das zweite Mal über den vorbestimmten Öffnungswinkel geschwenkt wird. Beim Öffnen wird nämlich das Türblatt ein erstes Mal über den vorbestimmten Öffnungswinkel und beim anschließenden Schließen ein zweites Mal geschwenkt.

Es kann auch vorgesehen sein, dass die von dem Magnetsensor erzeugten Signale während des Schwenkens des Türblatts ausgewertet werden, um einen Nordpol/Südpol Wechsel oder einen Südpol/Nordpol Wechsel des Dauermagneten beim Schwenken des Türblatts über den vorbestimmten Öffnungswinkel zu erkennen, um daraufhin die Vorrichtung nur bei sich schließendem Türblatt auszulösen. Hierbei wird die Poländerung der magnetischen Pole des Dauermagneten erkannt, sobald das Türblatt über den Öffnungswinkel geschwenkt wird. Da die Poländerung bei einem Öffnen und einem Schließen des Türblatts unterschiedlich sind, ist es dem Magnetsensor möglich, lediglich bei dem Öffnungswinkel des sich schließenden Türblatts auszulösen.

Das Scharnier ist vorzugsweise aus Metall. Vorzugsweise ist der Magnetsensor neben dem Scharnier innerhalb der Abdeckung angeordnet. Dadurch wird eine Gefahr einer negativen Beeinflussung des aus Metall gefertigten Scharniers auf den Magnetsensor zumindest verringert. Die Abdeckung weist insbesondere eine Trennwand auf, welche den Magnetsensor vom Scharnier trennt.

Die Abdeckung kann vorzugsweise eine die Trennwand aufweisende Kammer umfassen, innerhalb derer die Auslösevorrichtung angeordnet ist. Aufgrund dieser Kammer ist die Auslösevorrichtung gegen die Umwelt zumindest teilweise geschützt.

Die Auslösevorrichtung kann z.B. direkt an der Abdeckung befestigt sein. Gemäß einer Variante des erfindungsgemäßen Haushaltskältegerätes umfasst dieses einen Träger, an dem die Auslösevorrichtung befestigt ist. Der Träger ist an der Abdeckung befestigt. Der Träger ist vorzugsweise aus Kunststoff.

Vorzugsweise ist der Träger derart an der Abdeckung befestigt, dass er mit der gegebenenfalls vorhandenen Trennwand der Abdeckung eine Kammer bildet, innerhalb der die Auslösevorrichtung angeordnet ist. Dadurch kann die Auslösevorrichtung relativ einfach innerhalb der Kammer angeordnet werden.

Der Träger bildet vorzugsweise einen Wandabschnitt der Kammer. Dieser Wandabschnitt weist eine der Kammer zugewandte Seite und eine der Kammer abgewandte Seite auf. Die Auslösevorrichtung ist dann vorzugsweise an der der Kammer zugewandten Seite befestigt und die der Kammer abgewandte Seite des Trägers ist vorzugsweise dem Türblatt zugewandt. Insbesondere wenn die Auslösevorrichtung als der Magnetsensor ausgebildet ist bzw. den Magnetsensor aufweist, dann ist der Magnetsensor innerhalb der Kammer auf der der Kammer zugewandten Seite des Trägers befestigt und, da vorzugsweise die der Kammer abgewandte Seite des Trägers dem Türblatt zugewandt ist, sind Voraussetzungen geschaffen, dass beim Schwenken des Türblatts der Magnet zuverlässig in den Wirkbereich des Magnetsensors gelangen kann.

Ein Ausführungsbeispiel der Erfindung ist exemplarisch in den beigefügten schematischen Zeichnungen dargestellt. Es zeigen:
- Figur 1: einen Teil eines Haushaltskältegerätes mit einem Gehäuse und mit einem mittels Scharnieren schwenkbar am Gehäuse befestigten Türblatt,
- Figur 2: einen Ausschnitt des Haushaltskältegerätes,
- Figur 3: eines der Scharniere inklusive einer Abdeckung für das Scharnier und einen innerhalb der Abdeckung befestigten Träger für einen Magnetsensor,
- Figur 4: das Scharnier und den Träger mit dem Magnetsensor,
- Figur 5: den Träger ohne den Magnetsensor,
- Figuren 6, 7: verschiedene Ansichten der Abdeckung,
- Fig. 8: das Scharnier, den Magnetsensor und die Abdeckung,
- Fig. 9: eine Draufsicht des Haushaltskältegerätes, und
- Fig. 10: eine Kamera und eine Schnittstelle des Haushaltskältegerätes.

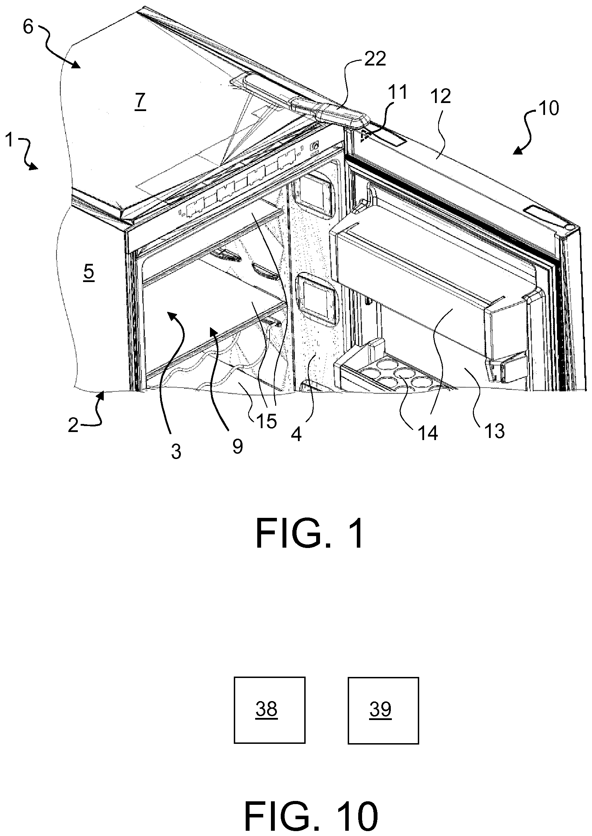

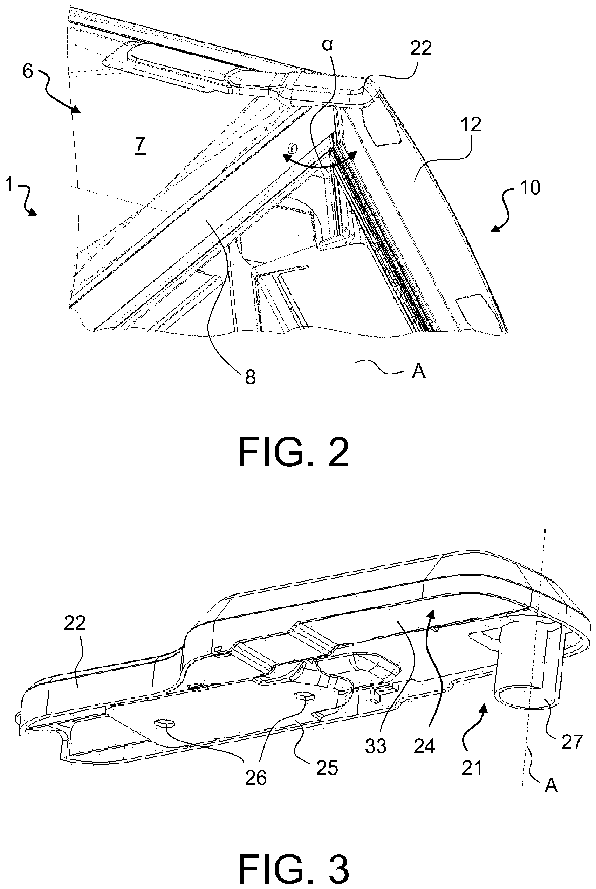

Die Figur 1 zeigt in einer perspektivischen Darstellung den oberen Teil eines Haushaltskältegeräts 1 und die Fig. 2 zeigt einen Ausschnitt des Haushaltskältegeräts 1.

Das Haushaltskältegerät umfasst ein wärmeisoliertes Gehäuse 2, das einen kühlbaren Innenraum 3 begrenzt. Der kühlbare Innenraum 3 ist zum Lagern von nicht näher dargestellten Lebensmitteln vorgesehen.

Das Gehäuse 2 umfasst dem kühlbaren Innenraum 3 zugewandte Seiten, welche vorzugsweise von einem Innenbehälter 4 gebildet werden, und dem kühlbaren Innenraum 3 abgewandte Seiten. Dazwischen ist eine Wärmeisolierung, vorzugsweise ein allgemein bekannter Isolierschaum angeordnet. Insbesondere weist das Gehäuse 2 zwei Seitenwände 5 und eine obere Wand 6 mit einer dem kühlbaren Innenraum 3 abgewandten, nach oben gerichteten Seite 7 auf. Das Gehäuse 2 bzw. der kühlbare Innenraum 3 weist eine rahmenartige Stirnseite 8 auf, welche eine Öffnung 9 des Gehäuses 2 umrahmt.

Das Haushaltskältegerät 1 umfasst eine nicht näher dargestellte, dem Fachmann im Prinzip bekannte Kältevorrichtung vorzugsweise in Form eines Kältemittelkreislaufs zum Kühlen des kühlbaren Innenraums 3. Der Kältemittelkreislauf umfasst z.B. einen Verdichter, einen dem Verdichter nachgeschalteten Verflüssiger, eine dem Verflüssiger nachgeschaltete Drosselvorrichtung, die insbesondere als ein Drossel- oder Kapillarrohr ausgeführt ist, und einen Verdampfer, der zwischen der Drosselvorrichtung und dem Verdichter angeordnet ist.

Das Haushaltskältegerät 1 umfasst im Falle des vorliegenden Ausführungsbeispiels eine nicht näher gezeigte elektronische Steuervorrichtung, welche eingerichtet ist, die Kältevorrichtung, insbesondere den Verdichter des Kältemittelkreislaufs in für den Fachmann in allgemein bekannter Weise derart anzusteuern, dass der kühlbare Innenraum 3 zumindest in etwa eine vorgegebene oder vorgebbare Soll-Temperatur aufweist. Die elektronische Steuervorrichtung ist vorzugsweise derart eingerichtet, dass sie die Temperatur des kühlbaren Innenraums 3 regelt. Um gegebenenfalls die Ist-Temperatur des kühlbaren Innenraums 3 zu erhalten, kann das Haushaltskältegerät 1 wenigstens einen nicht näher dargestellten und mit der elektronischen Steuervorrichtung verbundenen Temperatursensor aufweisen.

Das Haushaltskältegerät 1 kann genau einen kühlbaren Innenraum 3 aufweisen oder mehrere kühlbare Innenräume, die vorzugsweise übereinander angeordnet sind. Im letzteren Fall ist dann das Haushaltskältegerät 1 vorzugsweise eine Kühl-Gefrier-Kombination.

Das Haushaltskältegerät 1 weist ein schwenkbares Türblatt 10 zum Öffnen und Verschließen des kühlbaren Innenraums 3 bzw. dessen Öffnung 9 auf. Das Türblatt 10 ist insbesondere bezüglich einer vertikal verlaufenden Achse A relativ zum Gehäuse 2 schwenkbar mittels Scharnieren gelagert. Bei geöffnetem Türblatt 10, wie in der Fig. 1 dargestellt, ist der kühlbare Innenraum 3 durch dessen Öffnung 9 zugänglich.

Das Türblatt 10 umfasst insbesondere u.a. eine dem kühlbaren Innenraum 3 abgewandte Außenhaut, eine dem kühlbaren Innenraum 3 zugewandte Innenhaut 13, an der wenigstens ein Türabsteller 14 befestigt sein kann, und eine das Türblatt 10 nach oben hin abschließende Abschlussleiste 12. Der wenigstens eine Türabsteller 14 ist zum Lagern von Lebensmitteln vorgesehen.

Innerhalb des kühlbaren Innenraums 3 können zum Lagern der Lebensmittel vorgesehene Fachböden 15 angeordnet sein.

Die Scharniere sind insbesondere am Gehäuse 2 befestigt. Insbesondere ist das Türblatt 10 mittels eines oberen Scharniers 21 und mit einem nicht näher dargestellten unteren Scharnier schwenkbar gelagert.

Im Falle des vorliegenden Ausführungsbeispiels ist das obere Scharnier 21 an der dem kühlbaren Innenraum 3 abgewandten, nach oben gerichteten Seite 7 der oberen Wand 6 des Gehäuses 2 befestigt.

Das obere Scharnier 21 ist mittels einer Abdeckung 22 abgedeckt. Diese ist vorzugsweise aus Kunststoff gefertigt und einteilig.

Des Weiteren umfasst das Haushaltskältegerät 1 eine vorzugsweise als Magnetsensor 23 ausgeführte Auslösevorrichtung, welcher im Falle des vorliegenden Ausführungsbeispiels auf einem Träger 24 befestigt ist. Der Träger 24 ist wiederum an der Abdeckung 22 befestigt und wird von dieser abgedeckt. Es ist aber auch möglich, dass die Auslösevorrichtung bzw. der Magnetsensor 23 direkt in der Abdeckung 22 befestigt ist und von dieser abgedeckt wird. Der Träger 24 ist vorzugsweise aus Kunststoff.

Die Figur 3 zeigt in einer perspektivischen Darstellung von oben das obere Scharnier 21 inklusive der Abdeckung 22 und den Träger 24 für den Magnetsensor 23 von unten.

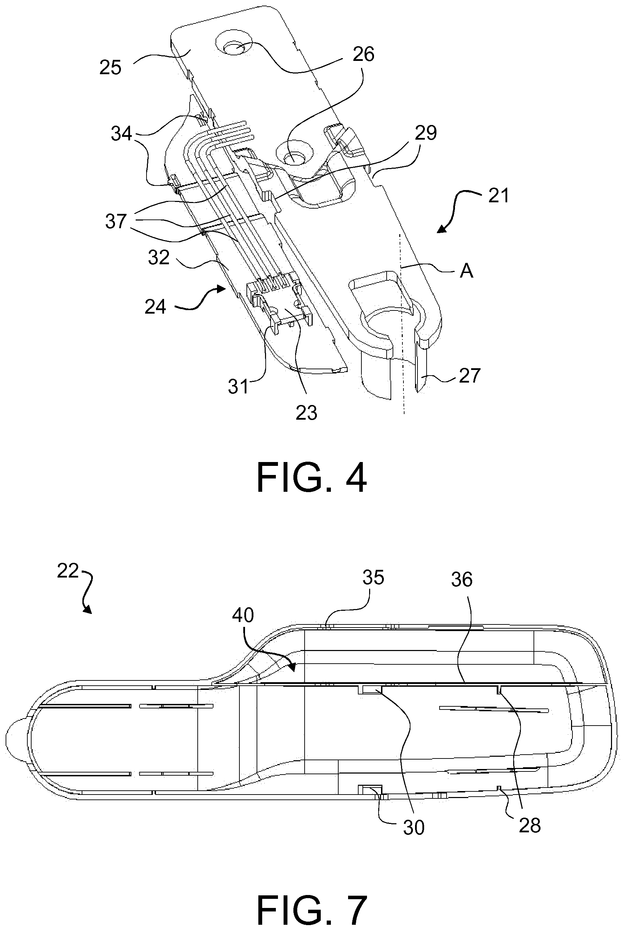

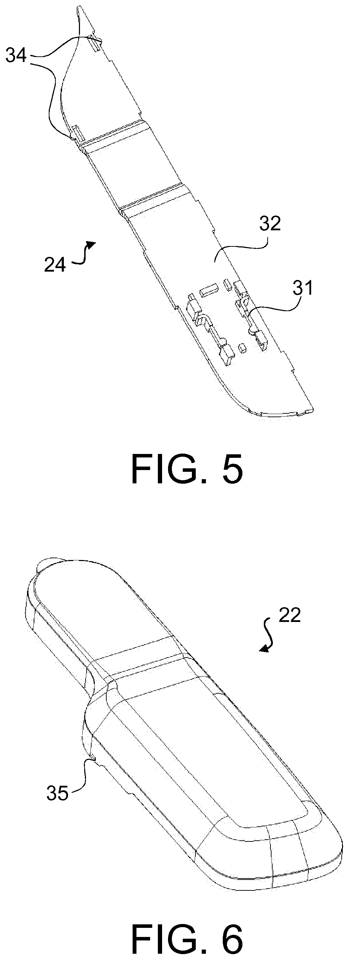

Die Figur 4 zeigt in einer perspektivischen Darstellung das obere Scharnier 21 und den Träger 24 mit daran befestigten Magnetsensor 23, jedoch mit entfernter Abdeckung 22 und die Figur 5 zeigt lediglich den Träger 24 ohne den Magnetsensor 23.

Die Figur 6 zeigt in einer perspektivischen Ansicht die Abdeckung 22 von oben und die Figur 7 zeigt die Abdeckung 22 von unten.

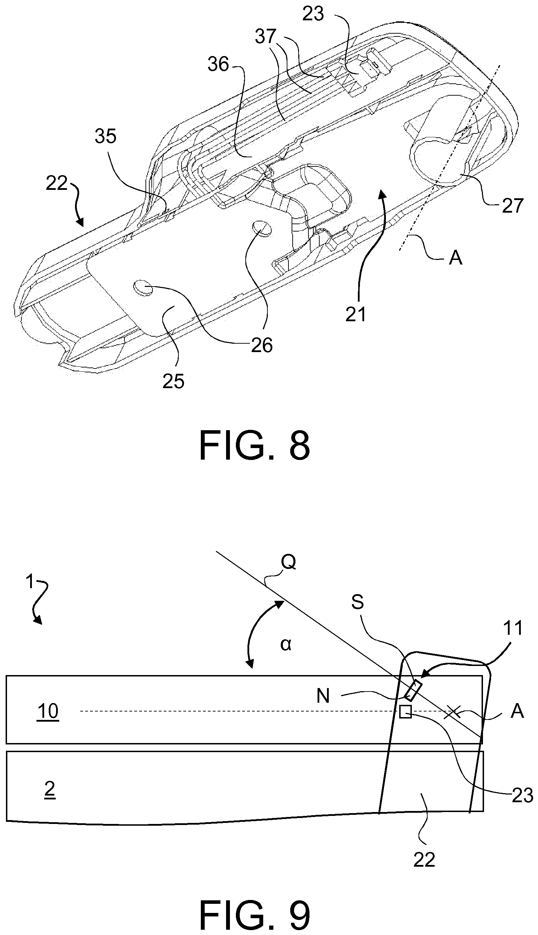

Die Figur 8 zeigt in einer perspektivischen Ansicht das obere Scharnier 21, den Magnetsensor 23 und die Abdeckung 22 von unten, jedoch ohne den Träger 24.

Das obere Scharnier 21 ist z.B. aus Metall und umfasst im Falle des vorliegenden Ausführungsbeispiels eine Befestigungsvorrichtung 25, mittels der das obere Scharnier 21 am Gehäuse 2 befestigt ist. Vorzugsweise ist die Befestigungsvorrichtung 25 des oberen Scharniers 21 plattenförmig ausgeführt und umfasst wenigstens eine Öffnung bzw. Bohrung 26, vorzugsweise mehrere Öffnungen bzw. Bohrungen 26, mittels derer das obere Scharnier 21 mit der oberen Wand 6 des Gehäuses 2 verschraubt ist.

Das obere Scharnier 21 umfasst im Falle des vorliegenden Ausführungsbeispiels eine Lagervorrichtung 27, welche vorzugsweise als eine kreiszylinderförmige Buchse ausgeführt ist. Die Lagervorrichtung 27 bzw. die Buchse ist vorgesehen, das Türblatt 10 schwenkbar zu lagern. Dazu umfasst das Türblatt 10 eine nicht näher gezeigte, der Lagervorrichtung 27 entsprechende Gegenlagervorrichtung, welche im Falle des vorliegenden Ausführungsbeispiels als eine der Buchse entsprechende Öffnung im Türblatt 10 ausgebildet ist. Mittels dieser Öffnung ist das Türblatt 10 in der Buchse eingehängt. Das obere Scharnier 21 bildet insbesondere einen Lagerwinkel.

Das obere Scharnier 21 ist vorzugsweise derart ausgeführt, dass die Lagervorrichtung 27 bzw. die Buchse über der Öffnung 9 des Gehäuses 2 bzw. über der Stirnseite 8 des Gehäuses 2 übersteht, sodass die Achse A vor dem Gehäuse 2 bzw. vor dessen Stirnseite 8 verläuft.

Im Falle des vorliegenden Ausführungsbeispiels ist die Abdeckung 22 an dem oberen Scharnier 21, insbesondere an dessen Befestigungsvorrichtung 25 befestigt, vorzugsweise mit dieser verrastet. Dazu umfasst im Falle des vorliegenden Ausführungsbeispiels die Abdeckung 22 Rasthaken 28, mittels derer die Abdeckung 22 am oberen Scharnier 21, insbesondere mit dessen Befestigungsvorrichtung 25 verrastet ist.

Im Falle des vorliegenden Ausführungsbeispiels weist die Befestigungsvorrichtung 25 des oberen Scharniers 21 zwei Aussparungen 29 auf, welche mit entsprechenden Stegen 30 der Abdeckung 21 zusammenwirken, damit die Abdeckung 30 möglichst genau relativ zum oberen Scharnier 21 positioniert und fixiert werden kann.

Im Falle des vorliegenden Ausführungsbeispiels ist der Magnetsensor 23 am Träger 24 befestigt, vorzugsweise mit diesem verrastet. Der Träger 24 umfasst insbesondere eine Befestigungsvorrichtung 31, mittels der der Magnetsensor 23 am Träger 24 befestigt ist. Die Befestigungsvorrichtung 31 des Trägers 24 umfasst z.B. mehrere Rasthaken für das Verrasten des Magnetsensor 23 mit dem Träger 24.

Der Träger 24 weist eine der oberen Wand 6 des Gehäuses 2 abgewandte Seite 32 und eine der oberen Wand 6 des Gehäuses 2 zugewandte Seite 33 auf. Im Falle des vorliegenden Ausführungsbeispiels ist es vorgesehen, dass der Magnetsensor 23 auf der oberen Wand 6 des Gehäuses 2 abgewandten Seite 32 des Trägers 24 am Träger 24 befestigt ist.

Der Träger 24 ist an der Abdeckung 22 befestigt, vorzugsweise mit dieser verrastet. Dazu umfasst der Träger 24 Rasthaken 34, welche mit entsprechenden Öffnungen 35 in der Abdeckung 22 verrasten.

Im Falle des vorliegenden Ausführungsbeispiels ist der Magnetsensor 23 neben dem Scharnier 21 angeordnet und die Abdeckung 22 umfasst eine Trennwand 36. Die Trennwand 36, der Träger 24 und die Abdeckung 22 bilden somit im Falle des vorliegenden Ausführungsbeispiels im Wesentlichen eine abgeschlossene Kammer 40, innerhalb der der Magnetsensor 23 angeordnet ist.

Insbesondere sind elektrische Leitungen 37 zur Versorgung des Magnetsensors 23 mit elektrischer Energie und zum Übertragen von mittels des Magnetsensors 23 erzeugter Signale vorgesehen.

Der Magnetsensor 23 ist derart angeordnet, dass er über der Öffnung 9 des Gehäuses 2 bzw. über der Stirnseite 8 des Gehäuses 2 an einer vorbestimmten Stelle übersteht, sodass der Wirkbereich des Magnetsensors 23 vor dem Gehäuse 2 bzw. vor dessen Stirnseite 8 verläuft.

Insbesondere ist es vorgesehen, dass der Magnetsensor 23 mit einem im oder am Türblatt 10 befestigten Magneten, insbesondere einem Dauermagneten 11 zusammenwirken vermag, sobald sich der Dauermagnet 11 im Wirkbereich des Magnetsensors 23 befindet.

Im Falle des vorliegenden Ausführungsbeispiels ist es vorgesehen, dass der Dauermagnet 11 derart im oder am Türblatt 10 in dessen oberen Bereich, vorzugsweise in oder an der oberen Abschlussleiste 12 befestigt ist, dass bei einem Schwenken des Türblatts 10 der Dauermagnet 11 bei einem vorbestimmten Öffnungswinkel α in den Wirkbereich des Magnetsensors 23 gerät. Der Öffnungswinkel α beträgt vorzugsweise etwa 50°. Dieser Zustand des Türblatts 10 ist in der Figur 2 gezeigt.

Im Falle des vorliegenden Ausführungsbeispiels ist es vorgesehen, dass der Magnetsensor 23 nur dann beim Öffnungswinkel α "auslöst", also ein Signal, insbesondere ein elektrisches Signal erzeugt, wenn das Türblatt 10 von seiner geöffneten Stellung in seine geschlossene Stellung geschwenkt wird und dabei den Öffnungswinkel a überstreicht. Bei einem Öffnen des Türblatts 10 soll der Magnetsensor 23 dagegen nicht "auslösen".

Um dies zu erreichen, kann es vorgesehen sein, dass der Dauermagnet 11 derart ausgerichtet, dass beim Schwenken des Türblatts 10 der Magnetsensor 23 eine Poländerung der magnetischen Pole des Dauermagneten 11 erkennt, sobald das Türblatt 10 über den Öffnungswinkel α geschwenkt wird. Da die Poländerung bei einem Öffnen und einem Schließen des Türblatts 10 unterschiedlich sind, ist es dem Magnetsensor 23 möglich, lediglich bei dem Öffnungswinkel α des sich schließenden Türblatts 10 auszulösen.

Die Fig. 9 zeigt eine Draufsicht das Haushaltskältegerät 1 mit geschlossenem Türblatt 10.

Der Dauermagnet 11 weist einen Nordpol N und einen Südpol S auf. Vorzugsweise ist der Dauermagnet 11 derart im oder am Türblatt 10 angeordnet, sodass dessen Nordpol N und Südpol S horizontal, vorzugsweise in Schwenkrichtung, ausgerichtet, sodass beim Schwenken des Türblatts 10 über den vorbestimmten Öffnungswinkel α der Magnetsensor 23 einen Nordpol/Südpol Wechsel und einen Südpol/Nordpol Wechsel des Dauermagneten 10, also die Poländerung des Dauermagneten 11 zu erkennen vermag. Aufgrund des erkannten Wechsels zwischen dem Nordpol N und dem Südpol S bzw. umgekehrt ist es verbessert möglich zu erkennen, wenn das Türblatt 10 den vorbestimmten Öffnungswinkel α aufweist. Insbesondere ist der Dauermagnet 11 derart im oder am Türblatt 10 befestigt und der Magnetsensor 23 in der Abdeckung 22, sodass sich bei dem vorbestimmten Öffnungswinkel α der Magnetsensor 23 über dem Äquator Q des Dauermagneten 11 bzw. dessen Verlängerung befindet.

Im Falle des vorliegenden Ausführungsbeispiels ist der Dauermagnet 11 derart im Türblatt 10 angeordnet, sodass sein Nordpol dem Gehäuse 2 zugewandt und sein Südpol vom Gehäuse abgewandt ist. Der Magnetsensor 23, der z.B. als ein Hall-Sensor ausgebildet ist, ist vorzugsweise ein unipolarer Magnetsensor, der im Falle des vorliegenden Ausführungsbeispiels Südpol empfindlich ist. Aufgrund dieser Ausrichtung des Dauermagneten 11 und der Wahl des Magnetsensors 23 gerät beim Schließen des Türblatts 11 zuerst der Nordpol N des Dauermagneten 11 in den Wirkbereich des Magnetsensors 23 und danach der Südpol S. Dadurch, dass der Magnetsensor 23 Südpol empfindlich ist, kann zuverlässig und mit relativ hoher Genauigkeit der Nordpol/ Südpol Wechsel erkannt und somit der vorbestimmte Öffnungswinkel α erkannt werden.

Der Magnetsensor 23 ist vorgesehen, wenigstens eine Vorrichtung des Haushaltskältegerätes 1 beim Überstreichen des Öffnungswinkel α des sich schließenden Türblatts 10 anzusteuern. Diese Vorrichtung ist im Falle des vorliegenden Ausführungsbeispiels als eine in der Fig. 10 gezeigte Kamera 38 ausgebildet.

Somit löst im Falle des vorliegenden Ausführungsbeispiels der Magnetsensor 23 wenigstens eine Kamera 38 des Haushaltskältegerätes 1 aus, sobald das sich schließende Türblatt 10 den Öffnungswinkel α überstreicht.

Vorzugsweise befindet sich der Magnetsensor 23 in der Drehflucht des Dauermagneten 11, d.h. bei dem vorbestimmten Öffnungswinkel α befindet sich der Magnetsensor 23 direkt über dem Dauermagneten 11.

Um zu erkennen, dass das Türblatt 10 aktuelle von seiner geöffneten Stellung in seine geschlossene Stellung geschwenkt wird, ist im Falle des vorliegenden Ausführungsbeispiels das Haushaltskältegerät 1 eingerichtet, ein Öffnen des Türblatts 10 durch Auswerten von Signalen, die ein Türöffnungsschalter des Haushaltskältegerätes 10 beim Öffnen des Türblatts 10 erzeugt, zu erkennen. Der Türöffnungsschalter ist nicht explizit gezeigt. Er ist jedoch dem Fachmann im Prinzip bekannt und wird normalerweise dafür verwendet, eine ebenfalls nicht gezeigte Innenraumbeleuchtung zum Beleuchten des kühlbaren Innenraums bei geöffnetem Türblatt 10 einzuschalten.

Danach werden die von dem Magnetsensor 23 erzeugten Signale während des Schwenkens des Türblatts 10 mit der elektronischen Steuervorrichtung ausgewertet, um einen Nordpol/Südpol Wechsel oder einen Südpol/Nordpol Wechsel des Dauermagneten 11 beim Schwenken des Türblatts 10 über den vorbestimmten Öffnungswinkel a zu erkennen. Die Vorrichtung bzw. die Kamera 38 wird nur dann ausgelöst, wenn nach dem erkannten Öffnen des Türblatts 10 aufgrund des Auswertens der vom Magnetsensor 23 erzeugten Signale erkannt wird, dass das Türblatt 10 das zweite Mal über den vorbestimmten Öffnungswinkel α geschwenkt wird. Beim Öffnen wird nämlich das Türblatt 10 ein erstes Mal über den vorbestimmten Öffnungswinkel α und beim anschließenden Schließen ein zweites Mal geschwenkt.

Die wenigstens eine Kamera 38 ist vorgesehen, ein Bild vom Inneren des kühlbaren Innenraums 3 zu erstellen bzw. einen dem Bild zugeordneten Bilddatensatz. Die Kamera 38 ist z.B. in oder an dem Türblatt 10 befestigt oder in oder an dem Innenbehälter 4.

Das Haushaltskältegerät 1 kann auch eine Schnittstelle 39 aufweisen, über die der Bilddatensatz an ein weiteres Gerät, z.B. ein mobiles Endgerät oder ein an das Internet angeschlossenes Gerät übertragen werden kann.

### BEZUGSZEICHENLISTE

- 1: Haushaltskältegerät
- 2: Gehäuse
- 3: kühlbarer Innenraum
- 4: Innenbehälter
- 5: Seitenwände
- 6: obere Wand
- 7: Seite
- 8: Stirnseite
- 9: Öffnung
- 10: Türblatt
- 11: Dauermagnet
- 12: obere Abschlussleiste
- 13: Innenhaut
- 14: Türabsteller
- 15: Fachböden
- 21: Scharnier
- 22: Abdeckung
- 23: Magnetsensor
- 24: Träger
- 25: Befestigungsvorrichtung
- 26: Bohrungen
- 27: Lagervorrichtung
- 28: Rasthaken
- 29: Aussparungen
- 30: Stege
- 31: Befestigungsvorrichtung
- 32, 33: Seite
- 34: Rasthaken
- 35: Öffnungen
- 36: Trennwand
- 37: elektrische Leitungen
- 38: Kamera
- 39: Schnittstelle
- 40: Kammer
- A: Achse
- N: Nordpol
- Q: Äquator
- S: Südpol
- α: Öffnungswinkel

## Patentansprüche

1. Haushaltskältegerät, aufweisend ein wärmeisoliertes Gehäuse (2), das einen zum Lagern von Lebensmitteln vorgesehenen, durch eine Öffnung (9) zugänglichen kühlbaren Innenraum (3) begrenzt, und das eine rahmenartige Stirnseite (8), welche die Öffnung (9) des Gehäuses (2) umrahmt, umfasst, eine zum Kühlen des kühlbaren Innenraums (3) vorgesehene Kältevorrichtung, ein mittels wenigstens eines Scharniers (21) bezüglich einer Achse (A) schwenkbar gelagertes Türblatt (10) zum Öffnen und Verschließen der Öffnung (9) des Gehäuses (2), eine zum Abdecken des Scharniers (21) vorgesehene Abdeckung (22), und eine innerhalb der Abdeckung (22) angeordnete Auslösevorrichtung, die als ein Magnetsensor (23) ausgebildet ist oder einen Magnetsensor (23) aufweist, der innerhalb der Abdeckung (22) angeordnet ist und mit einem in oder an dem Türblatt (10) befestigten Dauermagneten (11) für das Ansteuern einer Vorrichtung (38) des Haushaltskältegerätes zusammenwirkt, **dadurch gekennzeichnet, dass** die Auslösevorrichtung eingerichtet ist, wenigstens die Vorrichtung (38) des Haushaltskältegerätes (1) in Abhängigkeit eines Öffnungswinkels (α)) des Türblatts (10) anzusteuern, der Magnetsensor (23) innerhalb der Abdeckung (22) derart angeordnet ist, dass er an einer vorbestimmten Stelle vor der Stirnseite (8) des Gehäuses (2) angeordnet ist, sodass der Dauermagnet (11) sich dann im Wirkbereich des Magnetsensors (23) befindet, wenn das Türblatt (10) den vorbestimmten Öffnungswinkel (α)) aufweist, und der Dauermagnet (11) derart im oder am Türblatt (10) angeordnet ist, dass dessen Nordpol und Südpol horizontal insbesondere in Schwenkrichtung des Türblatts (10) ausgerichtet sind, und beim Schwenken des Türblatts (10) über den vorbestimmten Öffnungswinkel (α) der Magnetsensor (23) einen Nordpol/Südpol Wechsel und einen Südpol/Nordpol Wechsel des Dauermagneten (11) zu erkennen vermag.

2. Haushaltskältegerät nach Anspruch 1, **dadurch gekennzeichnet, dass** die mittels der Auslösevorrichtung ansteuerbare Vorrichtung eine Kamera (38) ist, welche eingerichtet ist, angesteuert durch die Auslösevorrichtung ein Bild vom kühlbaren Innenraum (3) zu erstellen, und/oder **dadurch gekennzeichnet, dass** das Gehäuse (2) eine nach oben gerichtete obere Wand (6) mit einem dem kühlbaren Innenraum (3) abgewandten Seite (7) aufweist, an der das Scharnier (21) befestigt ist.

3. Haushaltskältegerät nach Anspruch 1 oder 2, **dadurch gekennzeichnet, dass** die Auslösevorrichtung neben dem Scharnier (21) innerhalb der Abdeckung (22) angeordnet ist, wobei insbesondere die Abdeckung (22) eine Trennwand (36) aufweist, welche die Auslösevorrichtung von dem Scharnier (21) trennt.

4. Haushaltskältegerät nach Anspruch 3, **dadurch gekennzeichnet, dass** die Abdeckung (22) eine die Trennwand (36) aufweisende Kammer (40) umfasst, innerhalb derer die Auslösevorrichtung angeordnet ist.

5. Haushaltskältegerät nach einem der Ansprüche 1 bis 4, **gekennzeichnet durch** einen Träger (24), an dem die Auslösevorrichtung befestigt ist, und der Träger (24) an der Abdeckung (22) befestigt ist.

6. Haushaltskältegerät nach Anspruch 3 und 5, **dadurch gekennzeichnet, dass** der Träger (24) derart an der Abdeckung (22) befestigt ist, dass er mit der Trennwand (36) eine Kammer (40) bildet, innerhalb der die Auslösevorrichtung angeordnet ist.

7. Haushaltskältegerät nach Anspruch 6, **dadurch gekennzeichnet, dass** der Träger (24) einen Wandabschnitt der Kammer (40) bildet, dieser Wandabschnitt eine der Kammer (40) zugewandte Seite (32) und eine der Kammer (40) abgewandte Seite (33) aufweist, die Auslösevorrichtung an der der Kammer (40) zugewandten Seite befestigt ist, und die der Kammer (40) abgewandte Seite (33) des Trägers (24) dem Türblatt (10) zugewandt ist.

8. Haushaltskältegerät nach einem der Ansprüche 1 bis 7, **dadurch gekennzeichnet, dass** die Auslösevorrichtung eingerichtet ist, die Vorrichtung (38) nur bei einem Schwenken des Türblatts (10) von seiner geöffneten Stellung in seine geschlossene Stellung beim vorbestimmten Öffnungswinkel (α) anzusteuern.

9. Haushaltskältegerät nach einem der Ansprüche 1 bis 8, **dadurch gekennzeichnet, dass** es eingerichtet ist, ein Öffnen des Türblatts (10) insbesondere durch Auswerten von Signalen, die ein Türöffnungsschalter des Haushaltskältegerätes (1) beim Öffnen des Türblatts (10) erzeugt, zu erkennen, die von dem Magnetsensor (23) erzeugten Signale während des Schwenkens des Türblatts (10) auszuwerten, um insbesondere einen Nordpol/Südpol Wechsel oder einen Südpol/Nordpol Wechsel des Dauermagneten (11) beim Schwenken des Türblatts (10) über den vorbestimmten Öffnungswinkel (α)) zu erkennen, und die Vorrichtung nur dann auszulösen, wenn nach dem erkannten Öffnen des Türblatts (10) aufgrund des Auswertens der vom Magnetsensor (23) erzeugten Signale erkannt wird, dass das Türblatt (10) das zweite Mal über den vorbestimmten Öffnungswinkel (α)) geschwenkt wird.

10. Verfahren zum Betreiben eines Haushaltskältegerätes (1) nach einem der Ansprüche 1 bis 8, aufweisend folgende Verfahrensschritte:
- Schwenken des Türblatts (10), und
- Auswerten der von dem Magnetsensor (23) erzeugten Signale während des Schwenkens des Türblatts (10), um einen Nordpol/Südpol Wechsel oder einen Südpol/Nordpol Wechsel des Dauermagneten (11) beim Schwenken des Türblatts (10) über den vorbestimmten Öffnungswinkel (α)) zu erkennen, um daraufhin die Vorrichtung auszulösen.

11. Verfahren nach Anspruch 10, zusätzlich aufweisend folgende Verfahrensschritte:
- Erkennen eines Öffnen des Türblatts (10) insbesondere durch Auswerten von Signalen, die ein Türöffnungsschalter des Haushaltskältegerätes (10) beim Öffnen des Türblatts (10) erzeugt,
- Auswerten der von dem Magnetsensor (23) erzeugten Signale während des Schwenkens des Türblatts (10), um einen Nordpol/Südpol Wechsel oder einen Südpol/Nordpol Wechsel des Dauermagneten (11) beim Schwenken des Türblatts (10) über den vorbestimmten Öffnungswinkel (α)) zu erkennen, und
- Auslössen der Vorrichtung nur dann, wenn nach dem erkannten Öffnen des Türblatts (10) aufgrund des Auswertens der vom Magnetsensor (23) erzeugten Signale erkannt wird, dass das Türblatt (10) das zweite Mal über den vorbestimmten Öffnungswinkel (α)) geschwenkt wird.

12. Verfahren nach Anspruch 10, aufweisend Auswerten der von dem Magnetsensor (23) erzeugten Signale während des Schwenkens des Türblatts (10), um einen Nordpol/Südpol Wechsel oder einen Südpol/Nordpol Wechsel des Dauermagneten (11) beim Schwenken des Türblatts (10) über den vorbestimmten Öffnungswinkel (α) zu erkennen, um daraufhin die Vorrichtung nur bei sich schließendem Türblatt (10) auszulösen.

## Claims

1. Household refrigeration appliance, having a thermally insulated housing (2), which delimits a coolable interior chamber (3) that is provided for storing food and is accessible through an opening (9) and which comprises a frame-like end face (8) which frames the opening (9) of the housing (2), a refrigeration apparatus provided for cooling the coolable interior chamber (3), a door leaf (10) for opening and closing the opening (9) of the housing (2), said door leaf (10) being mounted by means of at least one hinge (21) in such a manner that it can pivot in relation to an axis (A), a cover (22) provided for covering the hinge (21) and a trigger apparatus arranged within the cover (22) which is designed as a magnetic sensor (23) or has a magnetic sensor (23) which is arranged within the cover (22) and interacts with a permanent magnet (11) fastened in or on the door leaf (20) for actuating an apparatus (38) of the household refrigeration appliance, **characterised in that** the trigger apparatus is designed to activate at least the apparatus (38) of the household refrigeration appliance (1) as a function of an opening angle (α) of the door leaf (10), the magnetic sensor (23) is arranged within the cover (22) such that it is arranged at a predetermined point upstream of the end face (8) of the housing (2) so that the permanent magnet (11) is then disposed in the operating area of the magnetic sensor (23) when the door leaf (10) has the predetermined opening angle (α), and the permanent magnet (11) is arranged in or on the door leaf (10) in such a manner that its north pole and south pole are aligned horizontally in particular in the pivot direction of the door leaf (10) and when the door leaf (10) pivots over the predetermined opening angle (α), the magnetic sensor (23) is able to recognise a north pole/south pole switch and a south pole/north pole switch of the permanent magnet (11).

2. Household refrigeration appliance according to claim 1, **characterised in that**
the apparatus that can be activated by means of the trigger apparatus is a camera (38), which is designed to be activated by the trigger apparatus (23) to produce an image of the coolable interior chamber (3) and/or **characterised in that** the housing (2) has an upper wall (6) facing upward with one face (7) facing away from the coolable interior chamber (3), to which the hinge (21) is fastened.

3. Household refrigeration appliance according to claim 1 or 2, **characterised in that**
the trigger apparatus (23) is arranged next to the hinge (21) within the cover (22), the cover (22) in particular having a separating wall (36), which separates the trigger apparatus (23) from the hinge (21).

4. Household refrigeration appliance according to claim 3, **characterised in that** the cover (22) comprises a chamber (40) having the separating wall (36), within which the trigger apparatus is arranged.

5. Household refrigeration appliance according to one of claims 1 to 4,
**characterised by** a support (24), to which the trigger apparatus is fastened, and the support (24) is fastened to the cover (22).

6. Household refrigeration appliance according to claim 3 and 5, **characterised in that** the support (24) is fastened to the cover (22) in such a manner that it forms a chamber (40) with the separating wall (36), within which the trigger apparatus is arranged.

7. Household refrigeration appliance according to claim 6, **characterised in that**
the support (24) forms a wall segment of the chamber (40), said wall segment has one face (32) facing the chamber (40) and one face (33) facing away from the chamber (40), the trigger apparatus is fastened to the face facing the chamber (40) and the face (33) of the support (24) facing away from the chamber (40) faces the door leaf (10).

8. Household refrigeration appliance according to one of claims 1 to 7,
**characterised in that** the trigger apparatus is designed only to activate the apparatus (38) as the door leaf (10) pivots from its open position to its closed position at a predetermined opening angle (α).

9. Household refrigeration appliance according to one of claims 1 to 8, **characterised in that** it is designed to recognise an opening of the door leaf (10) in particular by analysing signals generated by a door opening switch of the household refrigeration appliance (1) as the door leaf (10) opens, to analyse the signals generated by the magnetic sensor (23) as the door leaf (10) pivots, in order in particular to recognise a north pole/south pole switch or a south pole/north pole switch of the permanent magnet (11) as the door leaf (10) pivots over the predetermined opening angle (α) and only to trigger the apparatus when the opening of the door leaf (10) has been recognised from the analysis of the signals generated by the magnetic sensor (23) and it is recognised that the door leaf (10) is pivoting over the predetermined opening angle (α) for the second time.

10. Method for operating a household refrigeration appliance (1) according to one of claims 1 to 8, having the following method steps:
- pivoting the door leaf (10) and
- analysing the signals generated by the magnetic sensor (23) as the door leaf (10) pivots, in order to recognise a north pole/south pole switch or a south pole/north pole switch of the permanent magnet (11) as the door leaf pivots (10) over the predetermined opening angle (α), in order then to trigger the apparatus.

11. Method according to claim 10, also having the following method steps:
- recognising an opening of the door leaf (10) in particular by analysing signals generated by a door opening switch of the household refrigeration appliance (10) as the door leaf (10) opens,
- analysing the signals generated by the magnetic sensor (23) as the door leaf (10) pivots, in order to recognise a north pole/south pole switch or a south pole/north pole switch of the permanent magnet (11) as the door leaf (10) pivots over the predetermined opening angle (α) and
- only triggering the apparatus when the opening of the door leaf (10) has been recognised from the analysis of the signals generated by the magnetic sensor (23) and it is recognised that the door leaf (10) is pivoting over the predetermined opening angle (α) for the second time.

12. Method according to claim 10, having an analysis of the signals generated by the magnetic sensor (23) as the door leaf (10) pivots, in order to recognise a north pole/south pole switch or a south pole/north pole switch of the permanent magnet (11) as the door leaf (10) pivots over the predetermined opening angle (α), in order then only to trigger the apparatus as the door leaf (10) closes.

## Revendications

1. Appareil frigorifique électroménager présentant un caisson isolé thermiquement (2) qui délimite un espace interne pouvant être refroidi (3) accessible par le biais d'une ouverture (9) et prévu pour stocker des aliments, et qui comprend un parement de type cadre (8) qui encadre l'ouverture (9) du caisson (2), un dispositif frigorifique prévu pour refroidir l'espace interne pouvant être refroidi (3), un vantail de porte (10) monté de manière pivotante par rapport à un axe (A) au moyen d'au moins une charnière (21) destiné à ouvrir et fermer l'ouverture (9) du caisson (2), un cache (22) prévu pour recouvrir la charnière (21) et un dispositif de déclenchement disposé à l'intérieur du cache (22) qui est réalisé en tant que capteur magnétique (23) ou présente un capteur magnétique (23) qui est disposé à l'intérieur du cache (22) et coopère avec un aimant permanent (11) fixé dans ou au niveau du vantail de porte (10) pour commander un dispositif (38) de l'appareil frigorifique électroménager, **caractérisé en ce que** le dispositif de déclenchement est conçu pour commander au moins le dispositif (38) de l'appareil frigorifique électroménager (1) en fonction d'un angle d'ouverture (a) du vantail de porte (10), le capteur magnétique (23) est disposé à l'intérieur du cache (22) de telle sorte qu'il est disposé au niveau d'un emplacement prédéterminé devant le parement (8) du caisson (2), de sorte que l'aimant permanent (11) se trouve donc dans la zone d'action du capteur magnétique (23) lorsque le vantail de porte (10) présente l'angle d'ouverture (a) prédéterminé, et l'aimant permanent (11) est disposé dans ou au niveau du vantail de porte (10) de telle sorte que son pôle nord et son pôle sud sont orientés horizontalement en particulier dans la direction de pivotement du vantail de porte (10), et lors du pivotement du vantail de porte (10) selon l'angle d'ouverture (a) prédéterminé le capteur magnétique (23) est capable de reconnaître un changement pôle nord/pôle sud et un changement pôle sud/pôle nord de l'aimant permanent (11).

2. Appareil frigorifique électroménager selon la revendication 1, **caractérisé en ce que** le dispositif pouvant être commandé au moyen du dispositif de déclenchement est une caméra (38) qui est conçue pour générer, de manière commandée par le biais du dispositif de déclenchement, une image de l'espace interne pouvant être refroidi (3), et/ou **caractérisé en ce que** le caisson (2) présente une paroi supérieure dirigée vers le haut (6) avec un côté (7) opposé à l'espace interne pouvant être refroidi (3), côté au niveau duquel la charnière (21) est fixée.

3. Appareil frigorifique électroménager selon la revendication 1 ou 2, **caractérisé en ce que** le dispositif de déclenchement est disposé à côté de la charnière (21) à l'intérieur du cache (22), dans lequel en particulier le cache (22) présente une paroi de séparation (36) qui sépare le dispositif de déclenchement et la charnière (21).

4. Appareil frigorifique électroménager selon la revendication 3, **caractérisé en ce que** le cache (22) comprend une chambre (40) présentant la paroi de séparation (36), chambre à l'intérieur de laquelle le dispositif de déclenchement est disposé.

5. Appareil frigorifique électroménager selon l'une des revendications 1 à 4, **caractérisé par** un support (24) auquel le dispositif de déclenchement est fixé, et le support (24) est fixé au cache (22).

6. Appareil frigorifique électroménager selon les revendications 3 et 5, **caractérisé en ce que** le support (24) est fixé au cache (22) de telle sorte qu'il forme avec la paroi de séparation (36) une chambre (40) à l'intérieur de laquelle le dispositif de déclenchement est disposé.

7. Appareil frigorifique électroménager selon la revendication 6, **caractérisé en ce que** le support (24) forme une section de paroi de la chambre (40), cette section de paroi présente un côté (32) tourné vers la chambre (40) et un côté (33) opposé à la chambre (40), le dispositif de déclenchement est fixé au côté tourné vers la chambre (40) et le côté (33) opposé à la chambre (40) du support (24) est tourné vers le vantail de porte (10).

8. Appareil frigorifique électroménager selon l'une des revendications 1 à 7, **caractérisé en ce que** le dispositif de déclenchement est conçu pour commander le dispositif (38) uniquement lors d'un pivotement du vantail de porte (10) de sa position ouverte vers sa position fermée sous l'angle d'ouverture (a) prédéterminé.

9. Appareil frigorifique électroménager selon l'une des revendications 1 à 8, **caractérisé en ce qu'**il est conçu pour reconnaître une ouverture du vantail de porte (10) en particulier par le biais d'une analyse de signaux qu'un commutateur d'ouverture de porte de l'appareil frigorifique électroménager (1) génère lors de l'ouverture du vantail de porte (10), pour analyser les signaux générés par le capteur magnétique (23) pendant le pivotement du vantail de porte (10), pour reconnaître en particulier un changement pôle nord/pôle sud ou un changement pôle sud/pôle nord de l'aimant permanent (11) lors du pivotement du vantail de porte (10) selon l'angle d'ouverture (a) prédéterminé, et pour déclencher le dispositif uniquement lorsque, après l'ouverture reconnue du vantail de porte (10) sur la base de l'analyse des signaux générés par le capteur magnétique (23), il est reconnu que le vantail de porte (10) a pivoté la deuxième fois selon l'angle (a) prédéterminé.

10. Procédé destiné à faire fonctionner un appareil frigorifique électroménager (1) selon l'une des revendications 1 à 8, présentant les étapes de procédé suivantes :
- pivotement du vantail de porte (10), et
- analyse des signaux générés par le capteur magnétique (23) pendant le pivotement du vantail de porte (10) pour reconnaître un changement pôle nord/pôle sud ou un changement pôle sud/pôle nord de l'aimant permanent (11) lors du pivotement du vantail de porte (10) selon l'angle d'ouverture (a) prédéterminé pour ensuite déclencher le dispositif.

11. Procédé selon la revendication 10, présentant en outre les étapes de procédé suivantes :
- reconnaissance d'une ouverture du vantail de porte (10) en particulier par le biais d'une analyse de signaux que génère un commutateur d'ouverture de porte de l'appareil frigorifique électroménager (10) lors de l'ouverture du vantail de porte (10),
- analyse des signaux générés par le capteur magnétique (23) pendant le pivotement du vantail de porte (10) pour reconnaître un changement pôle nord/pôle sud ou un changement pôle sud/pôle nord de l'aimant permanent (11) lors du pivotement du vantail de porte (10) selon l'angle d'ouverture (a) prédéterminé, et
- déclenchement du dispositif uniquement lorsque, après l'ouverture reconnue du vantail de porte (10) sur la base de l'analyse des signaux générés par le capteur magnétique (23), il est reconnu que le vantail de porte (10) a pivoté la deuxième fois selon l'angle d'ouverture (a) prédéterminé.

12. Procédé selon la revendication 10, présentant une analyse des signaux générés par le capteur magnétique (23) pendant le pivotement du vantail de porte (10) pour reconnaître un changement pôle nord/pôle sud ou un changement pôle sud/pôle nord de l'aimant permanent (11) lors du pivotement du vantail de porte (10) selon l'angle d'ouverture (a) prédéterminé pour ensuite déclencher le dispositif uniquement lorsque le vantail de porte (10) se ferme.
